Europäisches Patentamt

European Patent Office

Office européen des brevets

(11) Publication number: **0 052 038**
**B1**

(12) **EUROPEAN PATENT SPECIFICATION**

(45) Date of publication of patent specification: **04.06.86**

(21) Application number: **81401665.5**

(22) Date of filing: **22.10.81**

(51) Int. Cl.⁴: **H 01 L 21/28,** H 01 L 21/30, H 01 L 29/72

(54) Method of fabricating integrated circuit structure.

(30) Priority: **23.10.80 US 199771**

(43) Date of publication of application: **19.05.82 Bulletin 82/20**

(45) Publication of the grant of the patent: **04.06.86 Bulletin 86/23**

(84) Designated Contracting States: **CH DE FR GB IT LI NL**

(56) References cited: **GB-A-1 352 044 US-A-4 201 603**

(73) Proprietor: **FAIRCHILD CAMERA & INSTRUMENT CORPORATION 464 Ellis Street Mountain View California 94042 (US)**

(72) Inventor: **Vora, Madhukar B. 110 Lansbury Court Los Gatos California 95030 (US)**

(74) Representative: **Chareyron, Lucien et al Schlumberger Limited Service Brevets c/o Giers 12, place des Etats Unis B.P. 121 F-92124 Montrouge Cédex (FR)**

## Description

### Background of the Invention
#### *Field of the Invention*

This invention relates to a method of fabricating an integrated circuit structure, such as a lateral transistor, and in particular to a method of fabricating an integrated circuit structure having a self-aligned contact to an active region.

#### *Prior Art*

Most present high performance transistor structures rely upon vertical transistors in which the active junctions are formed parallel to the surface of the silicon, and the emitter to collector currents therefore flow vertically. Such structures provide precise yet straightforward control of the transistor base width by virtue of the diffusion processes utilized in fabricating them. Existing diffusion processes permit manufacture of vertical bipolar transistors having a base width of 5,000 angstroms. Such transistors have a gain of approximately 100 and operate at frequencies up to approximately one gigaHertz.

The maximum switching frequency for such transistors has been limited by primarily two parameters — the total base resistance and the collector-base capacitance. Nonetheless using three micron integrated circuit layout rules these parameters have been low enough to permit switching speeds on the order of 1 to 3 nanoseconds. As integrated circuit processing technology moves closer to permitting 1 micron layout rules, very shallow junctions, and very narrow base widths, it is expected that transistors may usefully operate at frequencies of up to 10 gigaHertz. At such high frequencies switching performance will be almost completely dependent upon base resistance and collector-base capacitance.

Lateral transistors, of course, are well known. Different techniques of integrated circuit manufacture have been used to fabricate such transistors. One well known technique is to use a double diffusion process, for example, as taught by Schinella in United States Patent Nos. 3,919,005 or 3,945,857. Using this process, the transistor base is created by laterally and vertically diffusing into an epitaxial semiconductor layer formed over a buried layer, a base impurity of the desired conductivity type. Much of the base is then counter doped with a second diffusion of opposite conductivity type for the emitter or collector of the transistor. Suitably controlled, the second diffusion overdopes all but a narrow portion of the base impurity, resulting in the base width of the transistor being that portion of the structure not overdoped by the second diffusion. The semiconductor substrate forms the other of the collector or emitter. Contact to the base is made by the buried layer, while contact to the buried layer is made elsewhere by a doped region extending through the epitaxial layer to the buried layer. The doped region is the same conductivity type as the buried layer.

A second technique for fabricating lateral transistors in integrated circuit structures has been to deposit a line of masking material on the surface of an epitaxial layer and then diffuse impurities for the collector and emitter toward each other in the substrate from opposite sides of the line. The base region will be the portion of the epitaxial layer between the diffusion fronts of the emitter and the collector. Electrical contact to the base is made through a buried layer. Unfortunately, all of the above techniques suffer from several disadvantages. Each technique, because of the buried layer and the need to make electrical contact to it, creates a transistor structure which occupies an undesirably large area on the wafer. None of the techniques allows sufficient control over the processes involved to achieve base widths less than 1 micron. Further, diffusing the collector-emitter impurities for even slightly too long will overdope the semiconductor material which would otherwise form the base, and destroy the function of the transistor.

### Summary of the Invention

This invention is more particularly useful for fabricating a lateral transistor structure having a self-aligned base/base contact and a narrower base width than present lateral transistors. The narrower base allows virtually all of the electrons injected by the emitter to be transported across the base to the collector, and reduces the transit time for the injected electrons. This increases the speed at which the transistor may change states. Transistors fabricated according to this invention may have base widths on the order of 2,000 to 5,000 angstroms (200 to 500 nm), switch in less than 100 picoseconds, and have collector-base capacitances on the order of .001 picofarads.

According to the invention, a method of fabricating an integrated circuit structure, such as a lateral transistor, having a self-aligned contact to an active region includes the steps of forming a first layer comprising a conductive material on an underlying semiconductor substrate of first conductivity type and a second layer comprising a semiconductor material on the first layer, the second layer having an edge: defining a zone of impurity in the second layer by introducing a first impurity into the second layer through the edge: removing the first layer using the said zone of impurity as a mark whereby the unremoved portion of the first layer lying under the said zone defines a conductive contact member to the substrate: and introducing a second impurity having second conductivity type opposite to the first conductivity type into the substrate through the portions where the substrate is not overlaid by the conductive contact member to define at least one junction area between the active region under the conductive contact member and an active region including the second impurity. In some embodiments of the process of the invention each of the first and the second layers themselves will be made up of two or more layers. To describe these embodiments the individual layers within either the first or second layers will be referred to as "regions", although as will be explained each region may be a layer.

More specifically, in one embodiment of the invention, the underlying semiconductor substrate is P conductivity type silicon, and the first layer itself comprises three regions formed atop each other — a first region of polycrystalline silicon disposed directly on the semiconductor substrate, a region of a metal silicide formed upon the surface of the polycrystalline silicon, and first region of silicon dioxide formed atop the metal silicide. The second layer, which is formed upon the surface of the first layer also comprises a sandwich type structure including a second region of polycrystalline silicon and second region of silicon dioxide. Thus, in one embodiment of the invention five successive regions are formed on the semiconductor substrate; from bottom to top being polycrystalline silicon, a metal silicide, silicon dioxide, a second layer of polycrystalline silicon, and a second layer of silicon dioxide.

Using well known photolithographic integrated circuit processes, an edge in the sandwich layer (the polycrystalline-silicon dioxide sandwich) is defined by a masking and chemical etching procedure. In the resulting structure, the second region of polycrystalline silicon is exposed only along this edge, with its upper surface being protected by the second region of silicon dioxide and its lower surface being protected by the first layer.

A suitable impurity is then laterally diffused into the exposed edge of the second region of polycrystalline silicon to define the zone of impurity. Using a selective etchant, all of the second region of silicon dioxide and the second region of polycrystalline silicon are removed, except for that portion of the second region of polycrystalline silicon doped by the laterally diffused impurity.

Using this zone of doped polycrystalline silicon as a mask, exposed regions of the first region of silicon dioxide in the first layer are removed. Next, the thereby exposed portions of the regions of metal silicide and then the exposed portions of the polycrystalline silicon in the first layer are removed except where they are beneath the zone of doped polycrystalline silicon. By using an isotropic chemical etchant to remove the silicide and polycrystalline silicon, an overhang of the first region of silicon dioxide over these layers is created. A thin layer of an oxide of silicon may then be grown across the surface of the semiconductor substrate and along the edges of the polycrystalline silicon. All of this oxide, except those portions beneath the overhang of the first region of silicon dioxide, may then be removed by plasma etching, thereby permitting introduction of a second impurity into the semiconductor substrate. The regions of second impurity will define the emitter and collector of the transistor, while the intervening region defines the base. The overlying polycrystalline-metal silicide regions provide electrical contact to the base.

Brief Description of the Drawings

Fig. 1 is a cross-sectional view of a semiconductor substrate after formation of the first and second layers.

Fig. 2 shows the same cross-section after definition of an edge in the second layer.

Fig. 3 shows a subsequent cross-section after removal of all of the second layer except the doped portion.

Fig. 4 shows a subsequent cross-section after using the second layer as a mask for removal of a portion of the first layer.

Fig. 5 shows a subsequent cross-section after removal of all of the first layer except for that portion underlying the doped portion of the second layer.

Fig. 6 shows a subsequent cross-section after formation of oxide along the edges of the remaining first layer.

Fig. 7 shows a subsequent cross-section after formation of electrical contacts to the emitter and collector.

Fig. 8 is a top view of the structure shown in Fig. 7.

Detailed Description

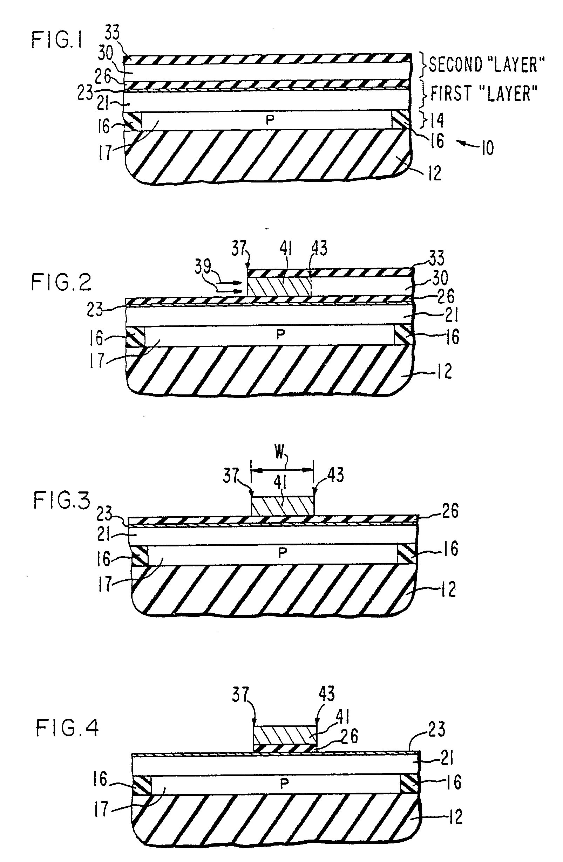

Fig. 1 is a cross-sectional view of an integrated circuit structure 10 which may be fabricated using well known techniques. On an insulating substrate 12 a layer of semiconductor material 14 is formed. Insulating substrate 12 may be any material which is not electrically conductive, and in one embodiment is a silicon dioxide layer formed on the upper surface of other semiconductor materials (not shown). Layer 14 will typically be monocrystalline silicon. Using known masking and etching techniques, for example, as taught by Peltzer in U.S. Patent 3,648,125, regions 16 of epitaxial layer 14 are converted to silicon dioxide. Then by ion implantation or other known integrated circuit process technology, a portion 17 of layer 14 is uniformly doped with P-conductivity type impurity, for example, boron at a concentration of $10^{17}$ atoms per cubic centimeter. In the preferred embodiment, layer 14 is 5,000 angstroms thick and is formed using any known technique, for example, silicon on sapphire deposition or by depositing polycrystalline silicon on silicon dioxide and then laser annealing to form single crystal silicon.

On the upper surface of semiconductor material 14, a first region of polycrystalline silicon 21 is deposited. Silicon layer 21 will typically be 3000 angstroms thick and formed by chemical vapor deposition processing. P+ impurity is then implanted in polycrystalline silicon 21, for example, using boron at a concentration of $10^{20}$ atoms per cubic centimeter. Such implantation typically will be shallow, for example, being performed at 20 to 30 keV. On the upper surface of region 21, a metal silicide 23, for example tungsten silicide, is formed by chemical vapor deposition.

On the upper surface of silicide 23, a layer of insulating material 26, typically silicon dioxide, is formed. Layer 26 will be approximately 1000 angstroms thick and fabricated by thermal oxidation of silicide 23, for example, at a temperature between 800°C, and 1000°C, or by vapor deposition of silicon dioxide. On silicon dioxide 26 a second region 30 of polycrystalline silicon is formed. This layer will be approximately 3000 angstroms thick and formed using the same process as region 21. On the upper surface of the second polycrystalline silicon region 30, a region of silicon dioxide 33 is formed. This layer typically will be 200 angstroms thick and formed by oxidizing polycrystalline silicon 30 at a temperature of 1000°C for one hour.

Using well known photolithographic techniques and a first mask, the structure in Fig. 2 may be obtained from that shown in Fig. 1. The first mask will define an edge 37 in silicon dioxide layer 33 and polycrystalline silicon layer 30. As will be explained, edge 37 will be used to define one edge of the base region of the lateral transistor to be formed in P-type silicon region 17.

As shown schematically in Fig. 2, suitable impurities 39, for example boron, are diffused laterally into layer 30. This may be accomplished using a well-known diffusion process carried out at a temperature of approximately 1000°C. The boron 39 will dope the polycrystalline silicon 30 to an impurity concentration of $10^{20}$ atoms per cubic centimeter. Because silicon dioxide layers 26 and 33 are relatively impervious to impurity diffusion, the boron 39 will diffuse into layer 30 and create a doped region 41. The diffusion front of impurity 39 in layer 30 is designated by dashed line 43 in Fig. 2. A substantial advantage of the invention is that the lateral position of front 43 with respect to edge 37 may be precisely controlled. For example, at a temperature of 1000°C and a boron source concentration of $10^{20}$ atoms per cubic centimeter, the diffusion front 43 will advance at a rate of approximately 1 micron per hour. This relatively slow advance of front 43 permits extremely accurate control of the width of the doped region 41 in layer 30. For example, in some embodiments, region 41 will be between 2,000 and 5,000 angstroms wide. As will be evident, accurate control of the width of doped region 41 permits accurate control of the width of the electrical connection to the base of the lateral transistor, and correspondingly, accurate control of the width of the base of the lateral transistor.

As shown in Fig. 3, silicon dioxide layer 33 and the regions of silicon layer 30 not doped by impurity 39 are next removed. Oxide layer 33 may be removed using conventional photolithographic technology and then an etchant, typically 10 parts water, 1 part hydrofluoric acid. This solution will also partially or completely remove the oxide layer 26 on the left side of doped polycrystalline silicon 41 not protected by overlying region 30. Removal of part or all of layer 26 will not affect the final structure because any remaining portions of the layer 26 are later removed anyway (See Fig. 4). The undoped portions of layer 30 may be removed using a known chemically selective etchant which attacks the undoped portions of layer 30 but not the doped portion 41. The structure which results after removal of oxide 33 and the undoped portions of layer 30 is shown in Fig. 3. The result of the process sequence through this step has been to create a region of doped polysilicon 41 having a precisely controlled width W as shown.

The doped polycrystalline silicone region 41 is then used as a mask for removal of oxide 26. In one embodiment of the invention, oxide 26 is removed using a known plasma etch process having parameters suitable for removing a layer of silicon dioxide approximately 1000 angstroms thick. The appearance of the structure after removal of the exposed oxide 26 is shown in Fig. 4.

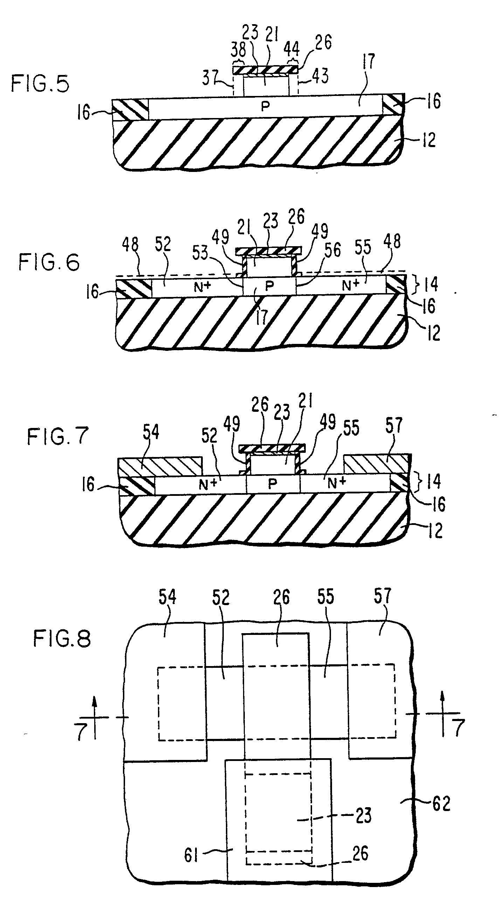

The structure of Fig. 4 is then further plasma etched to remove the exposed silicide 23 and the thereby exposed portions of the first region of polycrystalline silicon 21. A suitable plasma process for accomplishing this is the known planar plasma etching process. At the completion of the plasma etching, edges 37 and 43 will be defined in the regions 21 and 23. These edges are shown by the dashed lines in Fig. 5. The resulting structure is then chemically etched, for example, with a mixture of hydrofluoric and nitric acids, to undercut silicone dioxide layer 26, creating overhanging regions 38 and 44. This structure is depicted in Fig. 5. An overhang of 1000 angstroms has been found suitable.

A layer of silicon dioxide, comprising regions 48 and 49 is then grown across the surface of the silicon layer 14, including any portion of the P-type region 17. In one embodiment, layer 48 is 1000 angstroms thick and is formed by heating the structure shown in Fig. 5 in an atmosphere containing oxygen to a temperature of 1000°C for 30 minutes. This oxidation process will also create regions 49 shown in Fig. 6, because the exposed edges of silicon region 21 will also oxidize. A plasma etch using a planar plasma etching procedure may then be used to remove the undesired portions 48 of the silicon dioxide. During this process, silicon dioxide layer 26 will serve as a mask to prevent the removal of oxide regions 49. Next, as also shown in Fig. 6, N+ conductivity type impurities, for example phosphorous, may be diffused or implanted into the surface of region 17 to create N+ type regions 52 and 55 which extend to the bottom of layer 17, that is its interface with layer 12, and to permit lateral diffusion of the N type impurity to create the PN junctions 53 and 56 beneath protective oxide regions 49. In one embodiment regions 52 and 55 have impurity concentrations of approximately $10^{20}$ atoms per cubic centimeter.

Finally, as shown in Fig. 7, using well-known techniques, electrical connections 54 and 57 may be provided to the N+ type regions 52 and 55. Such connections may be fabricated using aluminum, alloys of aluminum with copper and/or silicon, or with other known integrated circuit metal systems, for example, tungsten-titanium alloys. Also, using known technology, the surface of the structure shown in Fig. 7 may be protected by forming a layer of vapor deposited silicon dioxide, or other suitable passivating material across its upper surface.

Fig. 8 is a top view of the structure shown in Fig. 7 with corresponding elements given the same reference numerals. Region 61, also metal, is used to make an electrical connection to the doped polycrystalline silicon base contact 21 by electrically connecting to silicide layer 23. That is, in Fig. 8, the region designated 23 has had the overlying oxide 26 removed to enable metal 61 to directly contact silicide 23.

The lateral transistor structure of this invention offers several advantages over existing structures. In particular, the structure provides a very narrow base having a self-aligned base contact. This eliminates the need for a buried layer and for a doped region to provide a connection between the buried layer and the surface of the integrated circuit. The substantial size reduction in the resulting lateral bipolar transistor allows higher packing densities and lower cost. The elimination of an extrinsic base region (the base contact is formed over substantially all of the base) allows faster operating speeds. Further, the intrinsic base resistant is very small because the width of the emitter may be determined by the thickness of the epitaxial silicon layer 14. Layers such as layer 14 may be readily fabricated less than 1 micron thick. In addition, there is no collector base junction beneath the extrinsic base, thereby reducing the collector-base capacitance. The area of the intrinsic base-collector junction is also small because this area depends upon the thickness of layer 14. The base width of the resulting structure is accurately controllable because the extent of the lateral diffusion of P dopants in the polycrystalline layer 30 may be accurately controlled.

The method of fabricating a lateral transistor described above provides several advantages over existing methods of fabricating such transistors. For example, only two masks are required prior to depositing metal and defining interconnections. The self-aligning electrical contact to the base region, the base region itself, and the PN junctions between the collector and base and between the emitter and base are all formed independent of alignment tolerances.

Although the invention has been described with reference to a specific embodiment, the description is illustrative of the invention and is not to be construed as limiting the invention. Various modifications and applications may occur to those skilled in the art without departing from the true scope of the invention as defined by the appended claims.

**Claims**

1. A method of fabricating an integrated circuit structure, such as a lateral transistor having a self-aligned contact to an active region, characterized by the steps of:

forming a first layer (21, 23, 26) comprising a conductive material on an underlying semiconductor substrate of first conductivity type (14) and a second layer (33, 30) comprising a semiconductor material on the first layer, the second layer having an edge (37);

defining a zone of impurity (41) in the second layer by introducing a first impurity (39) into the second layer (33, 30), through the edge (37);

removing the first layer (21, 23, 26) using the said zone of impurity (41) as a mask whereby the unremoved portion of the first layer lying under the said zone defines a conductive contact member to the substrate; and

introducing a second impurity having second conductivity type opposite to the first conductivity type into the substrate (14) through the portions where the substrate is not overlaid by the conductive contact member to define at least one junction area (53, 56) between the active region (17) under the conductive contact member and an active region (52, 55) including the second impurity.

2. A method as in claim 1 characterized in that after the step of removing the first layer the first layer (21, 23, 26) is laterally extended prior to the step of introducing the second impurity.

3. A method as in claim 2 characterized in that the first layer (21, 23, 26) is laterally extended by being oxidized.

4. A method as in claim 2 or 3 characterized in that the substrate (14) is P-conductivity type silicon:

the second impurity is N-conductivity type;

and the step of laterally extending the first layer protects the PN junctions (53, 56) created by introduction of the second impurity.

5. A method as in any one of claims 1 to 4 characterized in that the first layer (21, 23, 26) comprises a lower region (21), a middle region (23) and an upper region (26) of different materials.

6. A method as in any one of claims 1 to 5 characterized in that the second layer comprises an underlying region (30) and an overlying region (33) of different materials.

7. A method as in claims 5 and 6 characterized in that the upper region (26) of the first layer and the overlying region (33) of the second layer are resistant to diffusion of the first impurity.

8. A method as in any one of claims 5 to 7 characterized in that the lower region (21) is polycrystalline silicon and the first impurity is boron.

9. A method as in any one of claims 5 to 8 characterized in that the lower region (21) is polycrystalline silicon, the middle region (23) is a metal silicide, and the upper region (26) is an oxide of silicon.

10. A method of fabricating an integrated circuit structure such as a lateral transistor having a self-aligned contact to an active region characterized by the steps of:

forming a sandwich of at least four layers (21—23, 26, 30, 33) designated first through fourth from the bottom upward on a semiconductor substrate (14) of first conductivity type, the first layer being conductive and the third layer being a semiconductor;

removing portions of the third (30) and the fourth (33) layer to create an edge (37);

introducing a first impurity (39) into the third layer (30) through the edge (37) to create a zone of impurity (41), the second and the fourth layers (26, 33) being relatively impermeable to the impurity;

removing all of the third and the fourth layers (30, 33) except the zone of impurity;

removing all of the first and the second layers (21—23, 26) except those portions underlying the zone of impurity (41) whereby the unremoved portions of the first and second layers define a conductive contact member to the substrate (14);

removing an additional portion of the first layer (12—23) from the exposed sides of the first layer;

forming insulating material (49) on the thereby exposed sides of the first layer; and

introducing a second impurity of second conductivity type opposite to the first conductivity type into the semiconductor substrate (14) through the portions (52, 55) not overlaid by either one of the first layer (21—23) and the insulating material (49) to define at least one junction area (53, 56) between the active region (17) under the conductive contact member and an active region (52, 55) including the second impurity.

11. A method as in claim 10 characterized in that the first layer (21—23) includes a lower (21) and an upper (23) region.

12. A method as in claim 11 characterized in that the lower region (21) is polycrystalline silicon and the upper region (23) is a metal silicide.

## Patentansprüche

1. Verfahren zur Herstellung einer integrierten Schaltkreisstruktur, etwa eines lateralen Transistors, der einen selbstausgerichteten Kontakt zu einem aktiven Bereich aufweist, gekennzeichnet durch die Schritte: Bilden einer ersten Schicht (21, 23, 26) umfassend ein leitendes Material auf einem darunterliegenden Halbleitersubstrat eines ersten Leitfähigkeitstyps (14) und eine zweite Schicht (33, 30) umfassend ein Halbleitermaterial auf der ersten Schicht, wobei die zweite Schicht einen Rand (37) aufweist;

Definieren einer Verunreinigungszone (41) in der zweiten Schicht durch Einführen einer ersten Verunreingung (39) in die zweite Schicht (33, 30) durch den Rand (37);

Entfernen der ersten Schicht (21, 23, 26) unter Verwendung der besagten Verunreinigungszone (41) als eine Maske, wobei der nichtentfernte Teil der ersten Schicht, der unter der besagten Zone liegt, ein leitendes Kontaktglied zu dem Substrat definiert; und

Einführen einer zweiten Verunreinigung, die einen zweiten Leitfähigkeitstyp entgegengesetzt zu dem ersten Leitfähigkeitstyp besitzt, in das Substrat (14) durch die Abschnitte, wo das Substrat nicht durch das leitfähige Kontaktglied überdeckt ist, um wenigstens einen Grenzschichtbereich (53, 56) zwischen dem aktiven Bereich (17) unter dem leitenden Kontaktglied und einen aktiven Bereich (52, 55) umfassend die zweite Vereunigung zu definieren.

2. Verfahren wie in Anspruch 1, dadurch gekennzeichnet, daß nach dem Schritt des Entfernens der ersten Schicht die erste Schicht (21, 23, 26) vor dem Schritt des Einführens der zweiten Verunreinigung seitlich ausgedehnt wird.

3. Verfahren wie in Anspruch 2, dadurch gekennzeichnet, daß die erste Schicht (21, 23, 26) durch Oxidiertwerden seitlich ausgedehnt wird.

4. Verfahren wie in Anspruch 2 oder 3, dadurch gekennzeichnet, daß das Substrat (14) Silizium vom p-Leitfähigkeitstyp, die zweite Verunreinigung vom n-Leitfähigkeitstyp ist und der Schritt des seitlichen Ausdehnens der ersten Schicht die pn-Grenzschicht (53, 56) erzeugt durch Einführen der zweiten Verunreinigung schützt.

5. Verfahren wie in irgendeinem der Ansprüche 1 bis 4, dadurch gekennzeichnet, daß die erste Schicht (21, 23, 26) einen unteren Bereich (21), einen mittleren Bereich (23) und einen oberen Bereich (26) aus unterschiedlichen Materialien umfaßt.

6. Verfahren nach irgendeinem der Ansprüche 1 bis 5, dadurch gekennzeichnet, daß die zweite Schicht einen untenliegenden Bereich (30) und einen obenliegenden Bereich (33) unterschiedlicher Materialien aufweist.

7. Verfahren wie in Anspruch 5 und 6, dadurch gekennzeichnet, daß der obere Bereich (26) der ersten Schicht und der obenliegende Bereich (33) der zweiten Schicht gegenüber Diffusion der ersten Verunreinigung resistent sind.

8. Verfahren wie in irgendeinem der Ansprüche 5 bis 7, dadurch gekennzeichnet, daß der untere Bereich (21) polykristallines Silizium und die erste Verunreinigung Bor ist.

9. Verfahren wie in irgendeinem der Ansprüche 5 bis 8, dadurch gekennzeichnet, daß der untere Bereich (21) polykristallines Silizium, der mittlere Bereich (23) ein Metallsilicid und der obere Bereich (26) ein Siliziumoxid ist.

10. Verfahren zur Herstellung einer integrierten Schaltkreisstruktur, etwa eines lateralen Transistors, der einen selbstausgerichteten Kontakt, zu einem aktiven Bereich aufweist, gekennzeichnet durch die Schritte:

Bilden einer Sandwichstruktur aus wenigstens vier Schichten (21—23, 26, 30, 33), bezeichnet als erste bis vierte von der Bodenseite eines Halbleitersubstrats (14) eines ersten Leitfähigkeitstyps an aufwärts, wobei die erste Schicht leitend und die dritte Schicht ein Halbleiter sind;

Entfernen von Abschnitten der dritten (30) und der vierten (33) Schicht zum Erzeugen einer Kante (37);

Einführen einer ersten Verunreinigung (39) in die dritte Schicht (30) durch die Kante (37), um eine Verunreinigungszone (41) zu erzeugen, wobei die zweite und die vierte Schicht (26, 33) relativ undurchlässig für die Verunreinigung sind;

Entfernen der gesamten dritten und vierten Schicht (30, 33) abgesehen von der Verunreinigungszone;

Entfernen der gesamten ersten und zweiten Schicht (21—23, 26) abgesehen von denjenigen Abschnitten, die unter der Verunreinigungszone (41) liegen, wobei die nicht entfernten Abschnitte der ersten und zweiten Schicht ein leitendes Kontaktglied zu dem Substrat (14) definieren;

Entfernen eines zusätzlichen Abschnitts der ersten Schicht (21—23) von den freigelegten Seiten der ersten Schicht;

Bilden von isolierendem Material (49) an den dabei freiliegenden Seiten der ersten Schicht; und

Einführen einer zweiten Verunreinigung eines zweiten Leitfähigkeitstyps entgegengesetzt zu dem ersten Leitfähigkeitstyp in das Halbleitersubstrat (14) durch die Abschnitte (52, 55), die weder durch die erste Schicht (21—23) noch durch das isolierende Material (49) überdeckt sind, um wenigstens einen Grenzschichtbereich (53, 56) zwischen dem aktiven Bereich (17) unter dem leitenden Kontaktglied und einem aktiven Bereich (52, 55), der die zweite Verunreinigung einschließt, zu definieren.

11. Verfahren wie in Anspruch 10, dadurch gekennzeichnet, daß die erste Schicht (21—23) einen unteren (21) und einen oberen (23) Bereich umfaßt.

12. Verfahren wie in Anspruch 11, dadurch gekennzeichnet, daß der untere Bereich (21) polykristallines Silizium und der obere Bereich (23) ein Metallsilicid ist.

**Revendications**

1. Procédé de fabrication d'une structure de circuit intégré telle qu'un transistor latéral ayant un contact auto-aligné avec une région active, caractérisé par les étapes suivantes:

former une première couche (21, 23, 26) comprenant un matériau conducteur sur un substrat semi-conducteur sous-jacent d'un premier type de conductivité (14) et une deuxième couche (33, 30) comprenant un matériau semi-conducteur sur la première couche, la deuxième couche ayant un bord (37);

définir une zone d'impureté (41) dans la deuxième couche en introduisant une première impureté (39) dans la deuxième couche (33, 30) au travers du bord (37);

éliminer la première couche (21, 23, 26) en utilisant ladite zone d'impureté (41) comme masque de façon que la partie restante de la première couche se trouvant sous ladite zone définisse un contact conducteur sur le substrat; et

introduire dans le substrat (14) une deuxième impureté ayant un deuxième type de conductivité opposé au premier, au travers des parties où le substrat n'est pas surmonté par le contact conducteur, afin de définir au moins une surface de jonction (53, 56) entre la région active (17) située sous le contact conducteur et une région active (52, 55) contenant la deuxième·impureté.

2. Procédé selon la revendication 1, caractérisé en ce que, après l'étape d'élimination de la première couche, on prolonge latéralement la première couche (21, 23, 26) avant l'étape d'introduction de la deuxième impureté.

3. Procédé selon la revendication 2, caractérisé en ce que la première couche (21, 23, 26) est prolongée latéralement par oxydation.

4. Procédé selon la revendication 2 ou 3, caractérisé en ce que le substrat (14) est en silicium de type de conductivité P;

la deuxième impureté est de type de conductivité N; et

l'étape de prolongement latéral de la première couche protège les jonctions PN (53, 56) créées par introduction de la deuxième impureté.

5. Procédé selon l'une des revendications 1 à 4, caractérisé en ce que la première couche (21, 23, 26) comprend une région inférieure (21), une région médiane (23) et une région supérieure (26) de matériaux différents.

6. Procédé selon l'une des revendications 1 à 5, caractérisé en ce que la deuxième couche comprend une région sous-jacente (30) et une région supérieure (33) de matériaux différents.

7. Procédé selon les revendications 5 et 6, caractérisé en ce que la région supérieure (26) de la première couche et la région supérieure (33) de la deuxième couche sont résistantes à la diffusion de la première impureté.

8. Procédé selon l'une des revendications 5 à 7, caractérisé en ce que la région inférieure (21) est en silicium polycristallin et la première impureté est du bore.

9. Procédé selon l'une des revendications 5 à 8, caractérisé en ce que la région inférieure (21) est en silicium polycristallin, la région médiane (23) est un siliciure de métal et la région supérieure (26) est un oxyde de silicium.

10. Procédé de fabrication d'une structure de circuit intégré telle qu'un transistor latéral ayant un contact auto-aligné avec une région active, caractérisé par les étapes suivantes:

former un sandwich d'au moins quatre couches (21—23, 26, 30, 33) numérotées de la première à la quatrième du bas vers le haut, sur un substrat semi-conducteur (14) d'un premier type de conductivité, la première couche étant conductrice et la troisième couche étant un semi-conducteur;

éliminer des parties des troisième (30) et quatrième (33) couches pour créer un board (37);

introduire une premiere impureté (39) dans la troisième couche (30) au travers du bord (37) pour créer une zone d'impureté (41), les deuxième et quatrième couches étant relativement imperméables à cette impureté;

éliminer toute la troisième et toute la quatrième couche (30, 33) excepté la zone d'impureté;

éliminer toute la première et toute la deuxième couche (21—23, 26) excepté les parties sous-jacentes à la zone d'impureté (41) de façon que les parties restantes des première et deuxième couches définissent un contact conducteur sur le substrat (14);

éliminer, des côtés exposés de la première couche, une partie supplémentaire de la première couche (21—23);

former un matériau isolant (49) sur les côtés exposés de la première couche; et

introduire dans le substrat semi-conducteur (14) une deuxième impureté d'un deuxième type de conductivité opposé au premier, au travers des parties (52, 55) non surmontées soit par la première couche (21—23), soit par le matériau isolant (49), de façon à définir au moins une surface de jonction (53, 56) entre la région active (17) située sous le contact conducteur et une région active (52, 55) contenant la deuxième impureté.

11. Procédé selon la revendication 10, caractérisé en ce que la première couche (21—23) comprend une région inférieure (21) et une région supérieure (23).

12. Procédé selon la revendication 11, caractérisé en ce que la région inférieure (21) est en silicium polycristallin et la région supérieure (23) est un siliciure de métal.

FIG.1

33
30
26
23
21
16
17

SECOND "LAYER"
FIRST "LAYER"

14
16
10
12

P

FIG.2

37   41   43
39
33
30
26
23
21
16
17
16
12

P

FIG.3

W

37   41   43
23
21
16
17
26
16
12

P

FIG.4

37   43
41
26
23
21
16
17
16
12

P

FIG.5

FIG.6

FIG.7

FIG.8